# EUROPEAN PATENT SPECIFICATION

(11) **EP 3 886 173 B1**
(45) Date of publication and mention of the grant of the patent: **30.09.2026**
(21) Application number: 19887869.6
(22) Date of filing: 19.11.2019
(51) Int. Cl.: H10H 20/01, H10H 29/24

(54) **LIGHT EMITTING ELEMENT AND LIGHT EMITTING MODULE COMPRISING SAME**
LICHTEMITTIERENDES ELEMENT UND LICHTEMITTIERENDES MODUL DAMIT
DISPOSITIF ÉLECTROLUMINESCENT ET MODULE ÉLECTROLUMINESCENT LE COMPRENANT

(30) Priority: 21.11.2018 KR 20180144872
(43) Date of publication of application: 29.09.2021
(73) Proprietor: Seoul Viosys Co., Ltd, Ansan-si, Gyeonggi-do 15429 (KR)
(72) Inventor: LEE, Jin Woong, Ansan-Si Gyeonggi-do (KR); KIM, Kyoung Wan, Ansan-Si Gyeonggi-do (KR)
(74) Representative: Stolmár & Partner Patentanwälte PartG mbB
(86) International application number: PCT/KR2019/015826
(87) International publication number: WO 2020/106009

(56) References cited:
- WO-A1-2014/002535
- WO-A1-2015/095090
- WO-A1-2017/065545
- KR-A- 20120 068 795
- KR-A- 20130 031 377
- KR-A- 20160 005 827
- US-A1- 2012 261 678
- US-A1- 2015 151 380
- US-A1- 2016 225 740
- US-A1- 2017 103 921
- US-A1- 2018 240 950

## Description

### BACKGROUND

### 1. Technical Field

The present disclosure relates to a light emitting device and a light emitting module including the same, and more particularly, to a nitride-based light emitting device and a light emitting module including the same.

### 2. Related Art

A light emitting diode is an inorganic light source which is widely used in various fields such as a display device, a vehicle lamp and a general lighting. The light emitting diode has a long lifetime, low power consumption and quick response speed, and thus rapidly substitutes existing light sources.

The light emitting diode is formed on a wafer such as sapphire, and then diced into light emitting chips through a dicing process. Hereafter, the process of dicing the wafer into the light emitting chips will be described. US 2016/225740 A1 discloses a manufacturing method, in which a plurality of LED chips are obtained from a single wafer, separated by laser scribing, and mounted side by side into a module such that corresponding separation surfaces face each other. It does not disclose linear modified regions formed by laser irradiation to extend through the substrate.

US 2017/103921 A1 discloses a laser scribing method for separating LEDs, wherein a pattern of irradiated regions is formed along a scribing line, said regions having a linear shape extending all the way through the substrate. It does not disclose the formation of a LED module wherein corresponding separation surfaces of different LED chips face each other.

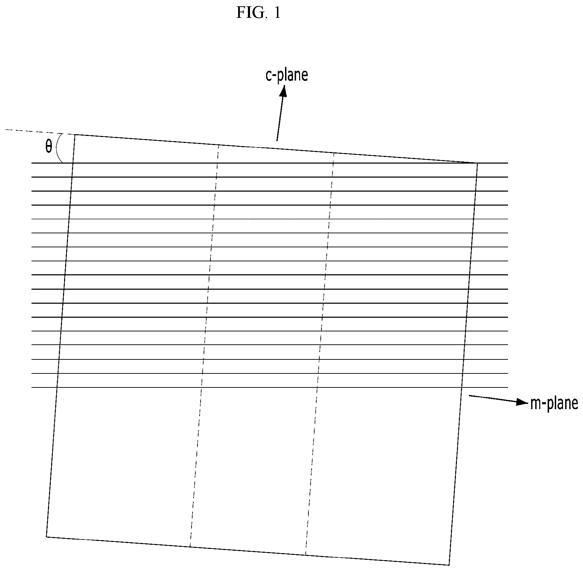

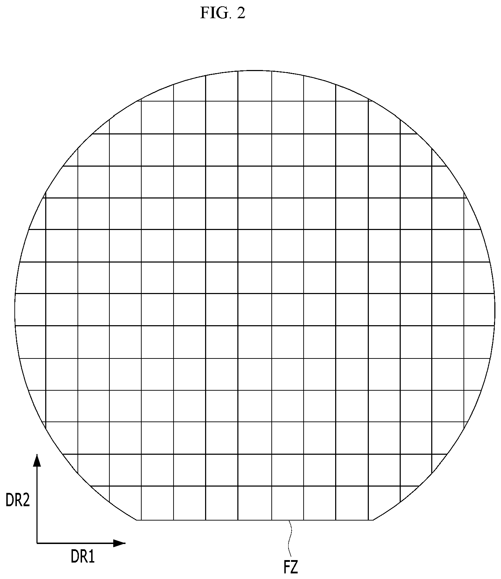

FIG. 1 is a cross-sectional view for describing a method for cutting an ingot to fabricate a wafer, and FIG. 2 is a cross-sectional view for describing the wafer of FIG. 1.

Referring to FIG. 1, a wafer WF having a flat zone FZ is formed by growing an ingot along a c-axis and cutting and processing the ingot. The ingot is cut at a predetermined angle θ off-axis from the c-axis. Therefore, when the wafer WF is diced into a plurality of chips, an m-plane exposed from a chip has a slope with respect to the top surface of the chip.

Referring to FIG. 2, a direction parallel to the extension direction of the flat zone FZ in the wafer WF is an m-axis. Hereafter, the m-axis direction is referred to as a first direction DR1, and a direction perpendicular to the m-axis is referred to as a second direction DR2. For example, the second direction DR2 is an a-axis. An a-plane is a plane which is exposed after the wafer WF is cut in the first direction DR1, and the m-plane is a plane which is exposed after the wafer WF is cut in the second direction DR2.

Through a general process, a plurality of light emitting diodes are formed on the wafer. Since this process is a publicly known technology, the detailed descriptions thereof will be omitted herein.

Then, the light emitting diodes formed on the wafer are diced through laser.

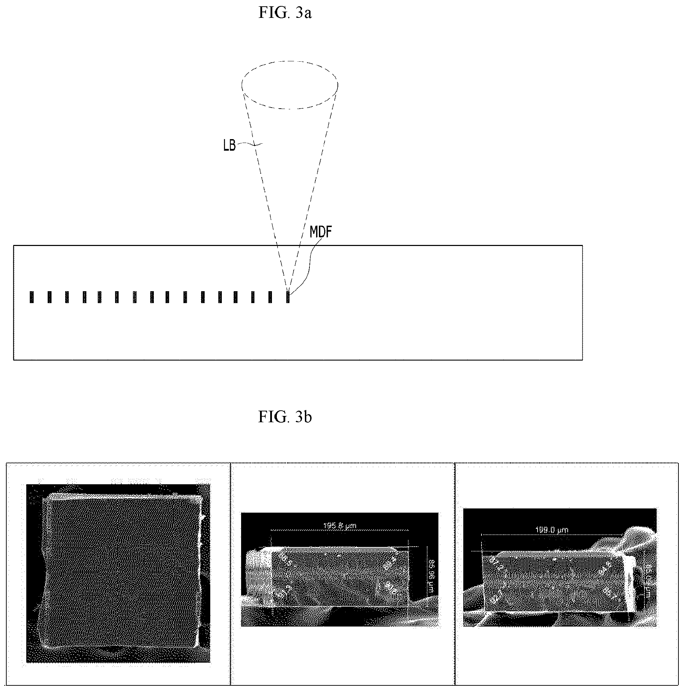

FIG. 3A is a schematic diagram for describing a conventional method using laser to cut a wafer.

Referring to FIG. 3A, dotted-type modified regions MDF are formed by concentrating and emitting a laser beam to a predetermined depth of the wafer. Then, the wafer is ruptured based on the modified regions, and separated into light emitting chips including light emitting diodes. The ruptured regions are extended in a direction perpendicular to the thickness direction of the wafer so as to connect the dotted-type modified regions.

Due to the crystal structure of the wafer, the wafer is more easily cut in the first direction than in the second direction. Therefore, although a smaller amount of laser beam is emitted in the second direction than in the first direction, the wafer is rapidly and easily cut in the second direction. The surface cut in the second direction has an inclined m-plane.

The light emitting chips cut through the conventional process each have a small size and a side surface inclined with the top surface thereof. Thus, while the light emitting chip is picked up and transferred to a target position, the light emitting chip may be rotated. In some cases, the light emitting chip may fall down on a circuit substrate onto which the light emitting chip was transferred, due to the inclined side surface. Furthermore, since the light emitting chips are arbitrarily rotated and mounted on the circuit substrate while being picked up and moved, the inclined side surfaces are irregularly arranged so that the lights generated from the plurality of light emitting chips mounted on the circuit substrate have irregular beam angles.

FIG. 3B shows photographs of the substrate formed through the method described with reference to FIG. 3A. In FIG. 3B, the left photograph is a photograph of the top surface of the substrate, the middle photograph is a photograph acquired by tilting a first side surface of the wafer cut in the first direction, and the right photograph is a photograph of a second side surface of the wafer cut in the second direction. A left portion of the middle photograph shows a part of the second side surface.

FIG. 3B shows that the cut substrate is tilted in one direction. FIG. 3B also shows that the angles between the top surface of the substrate and the first and second side surfaces include 84.3° and 95.4° that are somewhat different from 90°, which indicates that the cut substrate is inclined in one direction. Furthermore, FIG. 3B shows that the modified regions and the ruptured regions are parallel to the thickness direction of the substrate.

### SUMMARY

Various embodiments are directed to a light emitting chip having uniform luminance, and a light emitting module including the same.

The technical problems of the present disclosure are not limited to the above-mentioned technical problems, and other technical problems which are not mentioned herein will be clearly understood by those skilled in the art from the following descriptions.

The invention concerns a light emitting module as defined by appended claim 1.

Each of the modified regions may be modified by laser irradiation thereto.

The width of each of the ruptured regions may be larger than that of each of the modified regions.

The other side surface of the first substrate, adjacent to the one side surface thereof, may include a third modified surface, and the third modified surface may include modified regions extended in the thickness direction of the first substrate and ruptured regions disposed between the respective modified regions.

The width of each of the ruptured regions of the first modified surface may be smaller than that of each of the ruptured regions of the third modified surface.

When the first substrate includes sapphire, the one side surface of the first substrate may include an m-plane and a plane tilted with respect to the m-plane, and the other side surface of the first substrate may include an a-plane and a plane tilted with respect to the a-plane.

The ruptured regions of the third modified surface may have a first width, and the third modified surface may further include a cut region having a second width smaller than the first width, and formed between the corner at which the one side surface and the other side surface meet each other and the modified region which is the closest to the corner.

The one side surface of the first substrate may have a slope of 88.5° to 91.5° with respect to the interface between the first substrate and the first light emitting unit.

The one side surface of the second substrate may have a slope of 88.5° to 91.5° with respect to the interface between the second substrate and the second light emitting unit.

The ruptured regions of the first modified surface have a first width, and the first modified surface includes a cut region having a second width smaller than the first width, and formed between the corner at which the one side surface and the other side surface adjacent to the one side surface meet each other and the modified region which is the closest to the corner.

The first emitting unit may include: a first conductive type semiconductor layer disposed on one surface of the first substrate; an active layer disposed on the first conductive type semiconductor layer so as to expose a part of the first conductive type semiconductor layer; a second conductive type semiconductor layer disposed on the active layer so as to expose a part of the first conductive type semiconductor layer; a first reflecting layer configured to cover the first substrate, the first conductive type semiconductor layer, the active layer and the second conductive type semiconductor layer, and having a first hole and a second hole which expose the first and second conductive type semiconductor layers, respectively; a first pad disposed on the first reflecting layer, and electrically connected to the first conductive type semiconductor layer through the first hole; and a second pad disposed on the first reflecting layer, and electrically connected to the second conductive type semiconductor layer through the second hole.

The first reflecting layer may expose the edge of the one surface of the first substrate.

The light emitting module may further include a second reflecting layer disposed on the other surface of the first substrate, facing the one surface thereof on which the first light emitting unit is disposed.

The first reflecting layer may reflect two different wavelengths of lights, and the second reflecting layer may reflect one wavelength of light.

The first reflecting layer may have a larger thickness than the second reflecting layer.

The second reflecting layer may expose the edge of the other surface of the first substrate.

### BRIEF DESCRIPTION OF THE DRAWINGS

FIG. 1 is a cross-sectional view for describing a method for cutting an ingot to fabricate a wafer.
FIG. 2 is a cross-sectional view for describing the wafer of FIG. 1.
FIG. 3A is a schematic diagram for describing a conventional method using laser to cut a wafer.
FIG. 3B shows photographs of a substrate which is cut according to the conventional method.
FIGS. 4A, 4B, 5, 6A, 6B, 7, 8A, 8B, 9A, 9B, 10A, 10B, 11, 12, 13, 14A, 14B, 15A, 15B, 16A, 16B, 17A and 17B are cross-sectional view for describing a method for fabricating light emitting modules in accordance with an embodiment of the present disclosure.
FIG. 18A is a schematic diagram for describing a method using general laser to cut a wafer.
FIG. 18B shows photographs of a substrate formed through the method described with reference to FIG. 18A.

### DETAILED DESCRIPTION

In order to promote sufficient understandings of the configuration and effect of the present disclosure, exemplary embodiments of the present disclosure will be described with reference to the accompanying drawings. However, the present disclosure is not limited to the following embodiments disclosed below, but may be embodied in various shapes and modified in various manners.

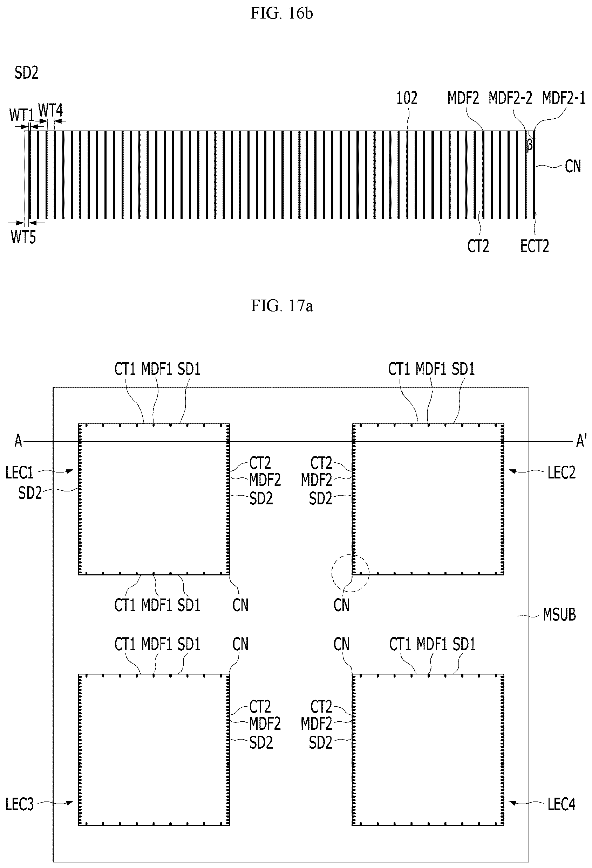

Furthermore, the terms used in the embodiments of the present disclosure may be analyzed as meanings that are typically known to those skilled in the art, unless the terms are defined differently. In the following description, the embodiment relating to a light emitting module described in relation to Figs.17A-17B is the only embodiment according to the invention as claimed. All other embodiments of the disclosure do not form part of the invention as claimed.

Hereafter, a light emitting chip in accordance with embodiments of the present disclosure will be described in detail.

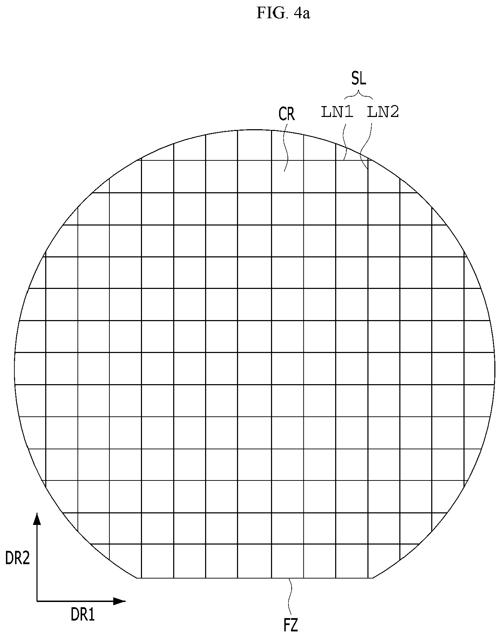

FIGS. 4A, 4B, 5, 6A, 6B, 7, 8A, 8B, 9A, 9B, 10A, 10B, 11, 12, 13, 14A, 14B, 15A, 15B, 16A, 16B, 17A and 17B are cross-sectional view for describing a method for fabricating a light emitting module in accordance with an embodiment of the present disclosure.

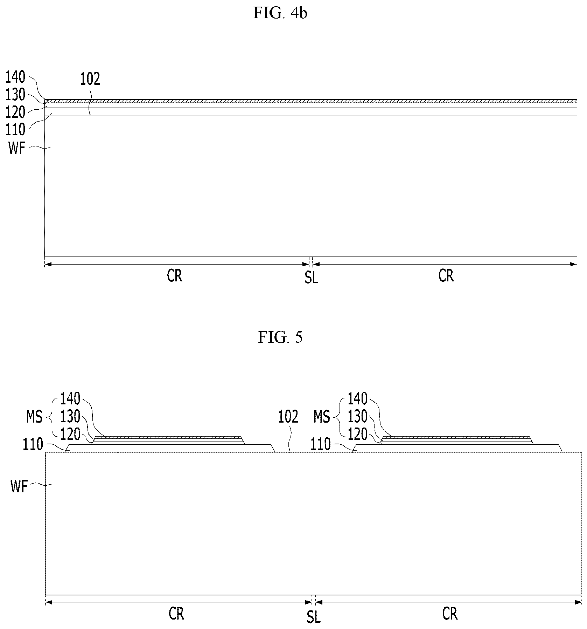

Referring to FIGS. 4A and 4B, a first conductive type semiconductor layer 110, an active layer 120, a second conductive type semiconductor layer 130 and an ohmic layer 140 may be formed over a wafer WF.

In accordance with an embodiment, the wafer WF may be a wafer WF acquired from an ingot of FIG. 1, and include sapphire. Referring to FIG. 4A, a direction parallel to the extension direction of a flat zone FZ in the wafer WF may be an m-axis. Hereafter, the m-axis direction is referred to as a first direction DR1, and a direction perpendicular to the m-axis is referred to as a second direction DR2. For example, the second direction DR2 may be an a-axis. An a-plane may be a plane which is exposed after the wafer WF is cut in the first direction DR1, and an m-plane may be a plane which is exposed after the wafer WF is cut in the second direction DR2.

In accordance with an embodiment, the wafer WF may include chip regions CR and a scribe line SL which defines the chip regions CR and isolates the chip regions CR from each other. Light emitting structures may be formed in the respective chip regions CR. For example, each of the chip regions CR has a square structure when seen from the top, and the scribe line SL may include first lines LN1 and second lines LN2. The first lines LN are extended in the first direction DR1 and parallel to each other, and the second lines LN2 are extended in the second direction DR2 and parallel to each other. The scribe line SL may have a mesh structure in which the first and second lines LN1 and LN2 cross each other.

For example, sapphire may have a crystal structure with Hexa-Rhombo R3c symmetry. Furthermore, sapphire has lattice constants of 13.001Å and 4.758Å in c-axis and a-axis directions, respectively, and includes a C (0001) surface, A (1120) surface, R (1102) surface and the like. The C surface of sapphire is stable at high temperature while a nitride thin film is easily grown thereon. Thus, sapphire may be used as a substrate for growing a nitride semiconductor.

The first conductive type semiconductor layer 110, the active layer 120 and the second conductive type semiconductor layer 130 may be formed over the wafer WF through a growth method such as MOCVD (Metal-Organic Chemical Vapor Deposition), MBE (Molecular Beam Epitaxy), HVPE (Hydride Vapor Phase Epitaxy) or MOC (Metal-Organic Chloride) .

The first conductive type semiconductor layer 110 may be a gallium nitride-based semiconductor layer doped with an n-type impurity, for example, silicon (Si). The second conductive type semiconductor layer 130 may be a gallium nitride-based semiconductor layer doped with a p-type impurity, for example, magnesium (Mg). Unlike the above-described structure, the first conductive type semiconductor layer 110 may be a p-type semiconductor layer, and the second conductive type semiconductor layer 130 may be an n-type semiconductor layer. Each of the first and second conductive type semiconductor layers 110 and 130 may be a single layer. However, each of the first and second conductive type semiconductor layers 110 and 130 is not limited thereto, but may have a multilayer or superlattice layer structure. The active layer 120 may include a MQW (Multi Quantum Well), and have a composition ratio that is determined to emit a desired peak wavelength of light. For example, the active layer 120 may emit light with a peak wavelength in a UV wavelength band or light with a peak wavelength in a blue wavelength band.

The ohmic layer 140 may be formed on the second conductive type semiconductor layer 130 through a deposition process such as CVD (Chemical Vapor Deposition). For example, TCO (Transparent Conductive Oxide) such as ITO (Indium Tin Oxide) or ZnO (Zinc Oxide) may be used as the ohmic layer 140.

Referring to FIG. 5, the ohmic layer 140, the second conductive type semiconductor layer 130 and the active layer 120 may be etched to form a plurality of mesa structures MS which expose the first conductive type semiconductor layer 110. Each of the mesa structures MS may be disposed in the chip region CR.

The first conductive type semiconductor layer 110 may be etched to form the first conductive type semiconductor layers 110 isolated from each other. The first conductive type semiconductor layer 110 may be disposed in the chip region CR. The mesa structure MS may have a smaller size than the first conductive type semiconductor layer 110, and partially expose the first conductive type semiconductor layer 110.

For example, after the mesa structures MS are formed, the first conductive type semiconductor layer 110 may be etched to isolate the elements. For another example, after the first conductive type semiconductor layer 110 is etched to isolate the elements, the mesa structures MS may be formed.

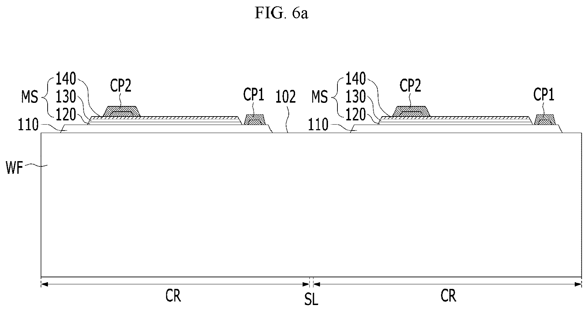

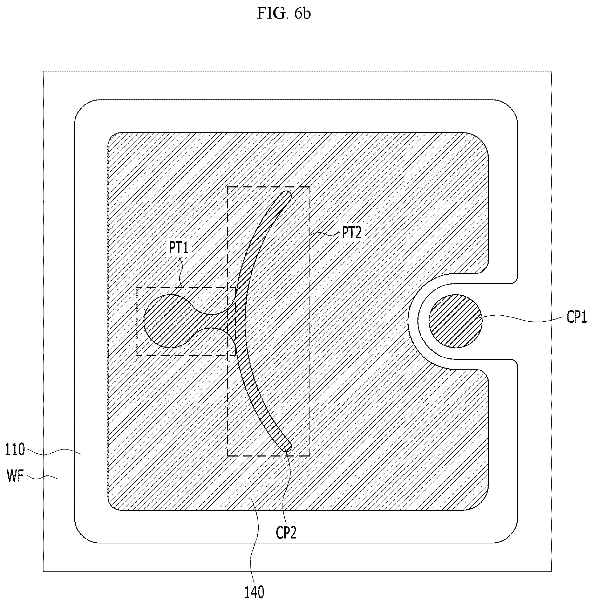

Referring to FIGS. 6A and 6B, a first conductive pattern CP1 may be formed on the first conductive type semiconductor layer 110 exposed by each of the mesa structures MS, and a second conductive pattern CP2 may be formed on each of the ohmic layers 140.

For example, each of the first and second conductive patterns CP1 and CP2 may include at least one selected from the group consisting of nickel (Ni), titanium (Ti), chrome (Cr), aluminum (Al), gold (Au) and tantalum (Ta).

In accordance with an embodiment, FIG. 6B is a plan view of the first and second conductive patterns CP1 and CP2 formed in one cell region CR, when seen from the first and second conductive patterns CP1 and CP2. As illustrated in FIG. 6B, the second conductive pattern CP2 may include a first part PT1 extended toward the first conductive pattern CP1 and a second part PT2 extended from the first part PT1 and extended in a direction perpendicular to a direction facing the first conductive pattern CP1. For example, the second part PT2 may have a structure in which the edges thereof are bent toward the first conductive pattern CP1. The second conductive pattern CP2 including the first and second parts PT1 and PT2 may be used to improve the current spread characteristic of the light emitting chip.

For example, a conductive layer may be formed over the wafer WF where the mesa structures MS and the first conductive type semiconductor layers 110 are formed. The conductive layer may have a multilayer structure. Then, the first and second conductive patterns CP1 and CP2 may be formed by performing a lift-off process on the conductive layer. The first conductive pattern CP1 may be electrically contacted with the first conductive type semiconductor layer 110, and the second conductive pattern CP2 may be electrically contacted with the ohmic layer 140.

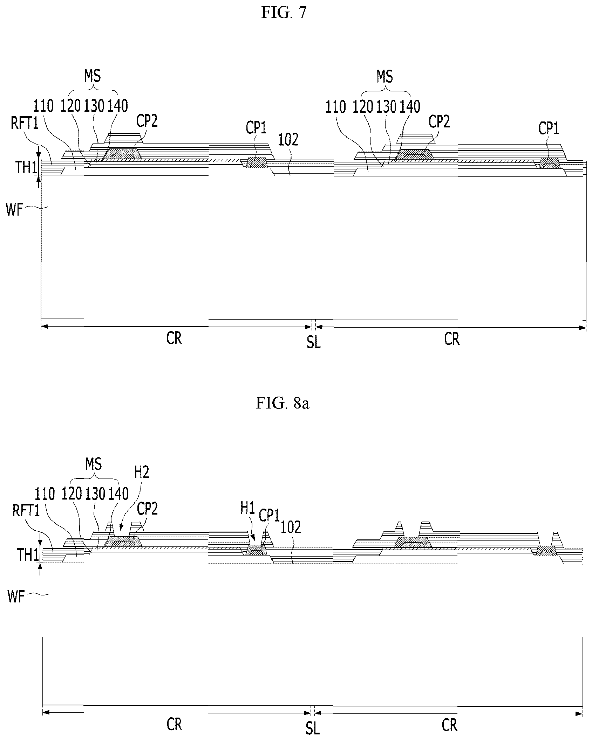

Referring to FIG. 7, a first reflecting layer RFT1 may be formed over the wafer WF so as to cover the first conductive patterns CP1, the second conductive patterns CP2, the mesa structures MS and the first conductive type semiconductor layers 110.

The first reflecting layer RFT1 may include a DBR (Distributed Bragg Reflector) having a structure in which silicon oxide (SiO₂) and titanium oxide (TiO₂) are alternately stacked. In accordance with an embodiment, the first reflecting layer RFT1 may reflect a plurality of lights having different wavelengths, and have a first thickness TH1. For example, the first reflecting layer RFT1 may include a first DBR and a second DBR, the first DBR may reflect a first wavelength of light, and the second DBR may reflect a second wavelength of light, shorter than the first wavelength. For example, the first DBR may reflect light of 550nm or 630nm, and the second DBR may reflect light of 460nm.

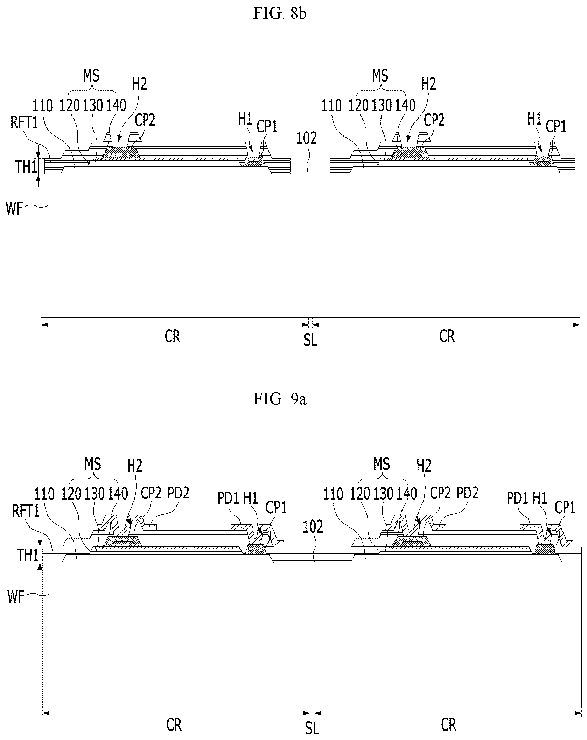

Referring to FIGS. 8A and 8B, the first reflecting layer RFT1 may be etched to form a first hole H1 which exposes the first conductive pattern CP1 and a second hole H2 which exposes the second conductive pattern CP2.

In accordance with the embodiment illustrated in FIG. 8B, the first reflecting layer RFT1 formed on the scribe line SL may be removed to expose the edge of each chip region CR, while the first and second holes H1 and H2 are formed. This is, in order to prevent damage to the first reflecting layer RFT1 during a subsequent laser process for cutting the wafer WF, the first reflecting layer RFT1 formed at the scribe line SL and the chip region CR adjacent to the scribe line SL, i.e. the edge of the chip region CR, may be etched.

The process of removing the first reflecting layer RFT1 of the scribe line SL may be omitted depending on the emission depth of laser beam LB. For example, when the emission depth of the laser beam LB (see FIG. 3A) is equal to the thickness of the polished wafer WF, the laser beam LB may have no influence on the first reflecting layer RFT1. Thus, as illustrated in FIG. 7, the process of removing the first reflecting layer RFT1 of the scribe line SL may be omitted.

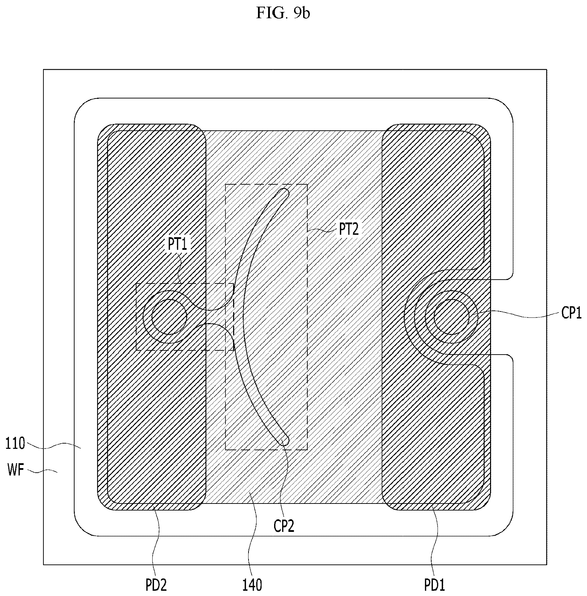

Referring to FIGS. 9A and 9B, a first pad PD1 and a second pad PD2 may be formed on the first reflecting layer RFT1 while filling the first and second holes H1 and H2, respectively.

For example, each of the first and second pads PD1 and PD2 may include at least one selected from the group consisting of aluminum (Al), nickel (Ni), titanium (Ti) and gold (Au). A pad layer may have a multilayer structure.

For example, the pad layer may be formed on the first reflecting layer RFT1 while filling the first and second holes H1 and H2. The pad layer may include the first pad PD1 and the second pad PD2 which are formed through a lift-off process. The first pad PD1 may be electrically contacted with the first conductive pattern CP1, and the second pad PD2 may be electrically contacted with the second conductive pattern CP2.

In this way, a plurality of light emitting structures may be formed on the wafer WF. The light emitting structures may be formed in the respective chip regions CR.

FIG. 9B is a plan view of one light emitting structure, when seen from the first and second pads PD1 and PD2.

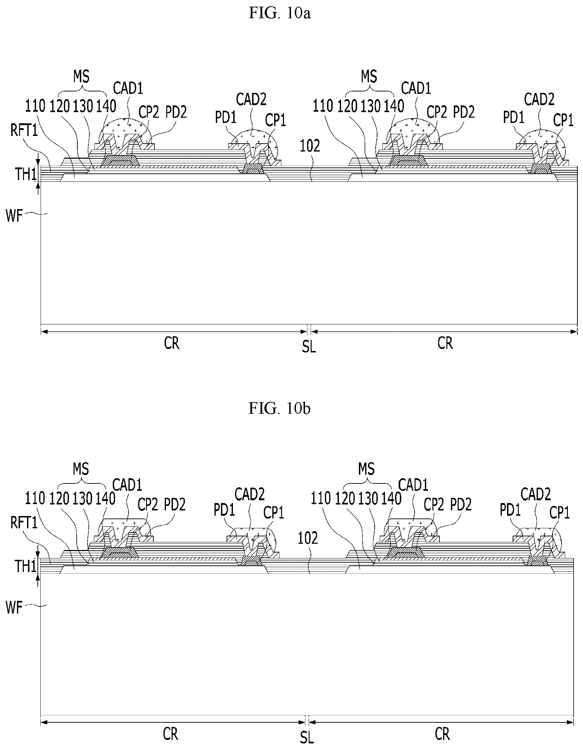

Referring to FIGS. 10A and 10B, a first conductive adhesion part CAD1 and a second conductive adhesion part CAD2 may be formed on the first pad PD1 and the second pad PD2, respectively.

In accordance with an embodiment, the first conductive adhesion part CAD1 and the second conductive adhesion part CAD2 may be formed through a stencil. Specifically, a stencil including openings to open the first and second pads PD1 and PD2 may be aligned on the wafer WF. The openings may be filled with conductive adhesive layers, respectively, in order to form the first conductive adhesion part CAD1 which electrically adheres to the first pad PD1 and the second conductive adhesion part CAD2 which electrically adheres to the second pad PD2. Each of the first and second conductive adhesion parts CAD1 and CAD2 may include at least one selected from the group consisting of indium (In), tin (Sn), nickel (Ni) and copper (Cu). Then, the stencil may be removed, and a reflow process may be performed on the first and second conductive adhesion parts CAD1 and CAD2. The first conductive adhesion part CAD1 may have one surface 102 abutting on the first pad PD1 and the other surface facing the one surface 102.

In accordance with the embodiment illustrated in FIG. 10A, the other surface of the first conductive adhesion part CAD1 may be formed as a curved surface. The second conductive adhesion part CAD2 may have one surface 102 abutting on the second pad PD2 and the other surface facing the one surface 102. The other surface of the second conductive adhesion part CAD2 may be formed as a curved surface.

In accordance with another embodiment illustrated in FIG. 10B, the tops of the first and second conductive adhesion parts CAD1 and CAD2 may be etched so that the other surfaces of the first and second conductive adhesion parts CAD1 and CAD2 are formed as flat surfaces. Hereafter, the first and second conductive adhesion parts CAD1 and CAD2 of FIG. 9B will be taken as an example for descriptions.

Selectively, the process of forming the first and second conductive adhesion parts CAD1 and CAD2 may be omitted.

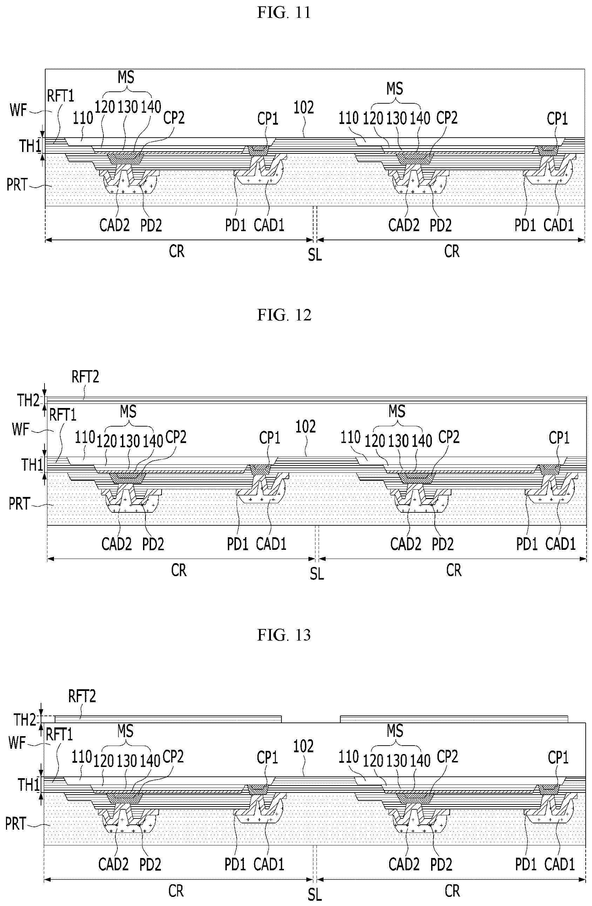

Referring to FIG. 11, one surface 102 of the wafer WF may be covered with a protective film PRT to protect the light emitting structures. The protective film PRT may be temporarily bonded to the light emitting structures through an attachable/detachable adhesive.

Then, the wafer WF may be turned upside down, and the other surface of the wafer, facing the one surface 102 thereof, may be ground and polished to reduce the thickness of the wafer WF.

While the wafer WF is ground and polished, the protective film PRT may protect the light emitting structures, and prevent particles from penetrating into the light emitting structures, the particles being generated by the wafer polishing process.

In the present embodiment, it is described that the first and second conductive adhesion parts CAD1 and CAD2 are first formed, and the other surface of the wafer WF is then ground and polished. However, the first and second conductive adhesion parts CAD1 and CAD2 may be formed after the other surface of the wafer WF is ground and polished.

Referring to FIG. 12, a second reflecting layer RFT2 may be formed on the polished other surface of the wafer WF.

The second reflecting layer RFT2 may include a DBR having a structure in which silicon oxide (SiO₂) and titanium oxide (TiO₂) are alternately stacked. In accordance with an embodiment, the second reflecting layer RFT2 may have a second thickness TH2 smaller than the first thickness TH1 of the first reflecting layer RFT1. The second reflecting layer RFT2 may reflect a second wavelength of light.

Referring to FIG. 13, the second reflecting layer RFT2 formed on the scribe line SL may be etched to expose the edge of each chip region CR.

This is in order to prevent damage to the second reflecting layer RFT2 during a subsequent laser emitting process for cutting the wafer WF. The scribe line SL and the second reflecting layer RFT2 formed in the chip region CR adjacent to the scribe line SL, i.e. the edge of the chip region CR, may be partially etched.

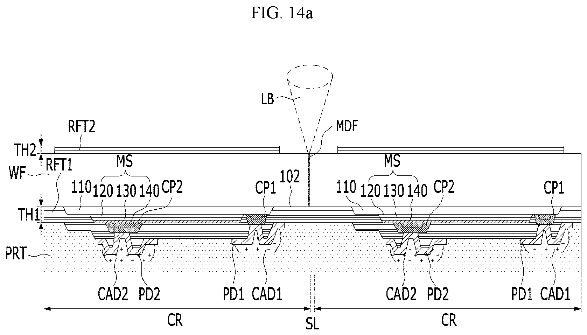

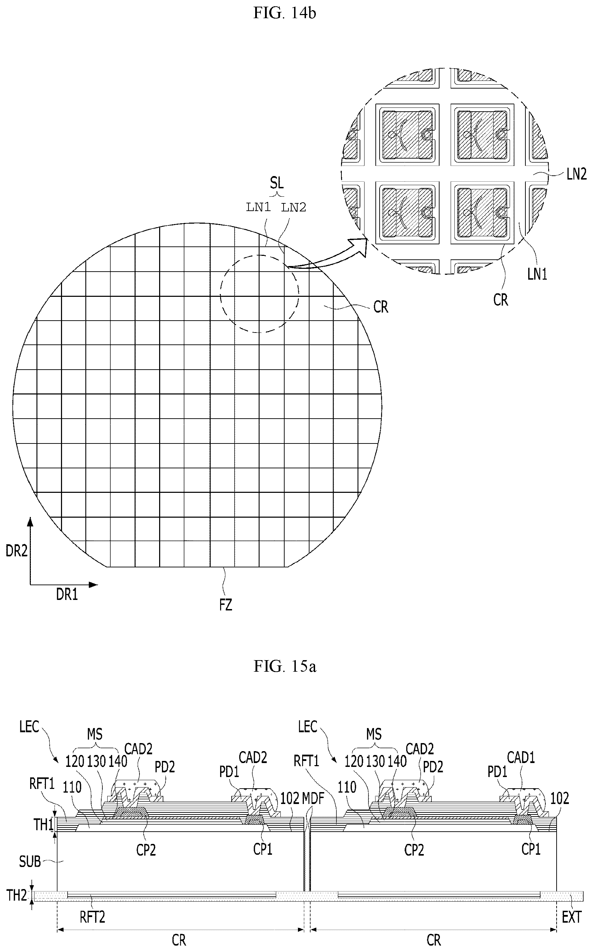

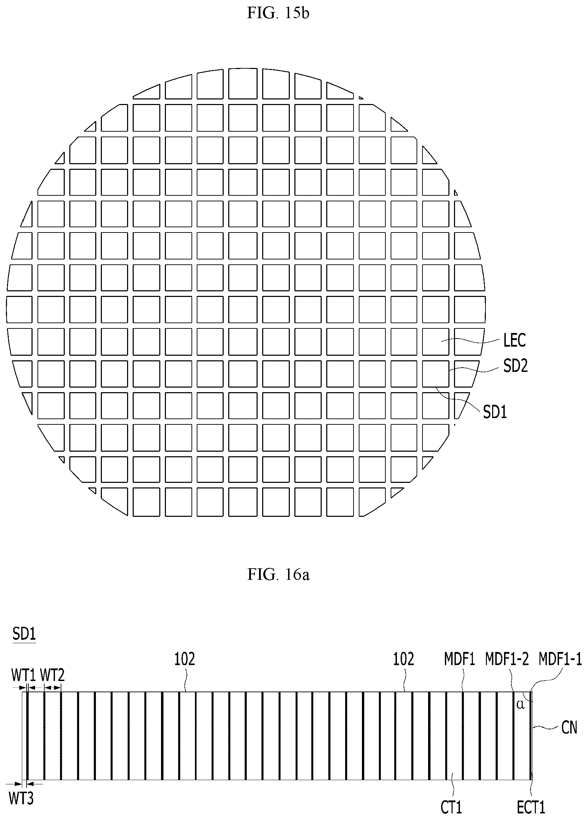

Referring to FIGS. 14A, 14B, 16A and 16B, modified regions MDF are formed by emitting the laser beam LB along the scribe line SL of the wafer WF. The modified regions MDF may include first modified regions MDF1 formed in the first direction DR1 and second modified regions MDF2 formed in the second direction DR2.

In accordance with an embodiment, the laser beam LB may be emitted through femtosecond laser having an ultra short pulse width of several to several hundreds of 10⁻¹⁵ femtoseconds. When the short pulse width and high peak power of the femtosecond laser are used, the time during which the laser pulse is emitted may become shorter than the thermal diffusion time of the wafer WF, which makes it possible to perform non-thermal processing without thermal degradation in the material within the wafer WF. Since the femtosecond laser generates high peak power by using a smaller amount of energy than existing continuous-wave laser or nanosecond laser, an impact to the wafer WF may be reduced. Furthermore, since the femtosecond laser has a nonlinear optical effect referred to as multi-photon absorption, the femtosecond laser may be used for a smaller width than the diffraction limit of laser beam.

The multi-photon absorption will be briefly described as follow. When the energy hv of photon is smaller than the absorption band gap EG of a material, the material becomes optically transparent. Therefore, the condition in which absorption occurs in the material is hv>EG. However, when the strength of the laser beam LB is extremely increased even though the material is optically transparent, absorption occurs in the material under a condition of nhv>EG where n is a natural number equal to or more than 2. This phenomenon is referred to as the multi-photon absorption. In the case of a pulse wave, the strength of the laser beam LB is determined by the peak power density (W/cm²) of the laser beam LB. For example, the multi-photon absorption occurs under the condition in which the peak power density is 1×10⁸ W/cm².

In accordance with an embodiment, the first modified regions MDF1 are formed by emitting the laser beam LB along the first lines LN1 of the scribe line SL. The laser beam LB is continuously emitted in the thickness direction of the wafer WF, and emitted with a first isolation distance in the first direction DR1. The first modified regions MDF1 are formed in a lined shape in which the first modified regions MDF1 are continuously extended in the thickness direction of the wafer WF, and isolated by the first isolation distance from each other.

The second modified regions MDF2 may be formed by emitting the laser beam LB along the second lines LN2 of the scribe line SL. The laser beam LB may be continuously emitted in the thickness direction of the wafer WF, and emitted with a second isolation distance in the second direction DR2. The second modified regions MDF2 may be formed in a lined shape in which the second modified regions MDF2 are continuously extended in the thickness direction of the wafer WF, and isolated, by the second isolation distance smaller than the first isolation distance, from each other.

The laser beam emitting process may be performed more densely and more frequently in the second direction DR2 than in the first direction DR1. Therefore, the number of the second modified regions MDF2 may be larger than the number of the first modified regions MDF1, and the second modified regions MDF2 may be formed more densely than the first modified regions MDF1. In accordance with an example, the second modified regions MDF2 may overlap each other.

Since a surface which is cut in the second direction DR2 and exposed to the outside includes an m-plane and has a crystal structure in which the m-plane is a crystal plane, it may be easier to cut the wafer WF in the second direction DR2 than in the first direction DR1.

As described above, however, the inclined m-plane may be formed when the ingot is cut to fabricate the wafer WF. Therefore, when the ingot is more quickly cut in the second direction DR2 than in the first direction DR1 as in the related art, the exposed m-plane may be inclined with respect to the one surface 102 of the substrate. Thus, as the laser beam LB is not only more densely and more frequently emitted in the second direction DR2 but also continuously emitted in the thickness direction of the wafer WF, the second modified regions MDF2 may be formed perpendicular to the one surface 102 of the wafer WF.

In accordance with an embodiment, the width between the first modified regions MDF1 and the width between the second modified regions MDF2 may be adjusted by the emission speed of the femtosecond laser. While the wafer WF is fixed, the speed at which the femtosecond laser is emitted in the first direction DR1 may be adjusted to higher speed than the speed at which the femtosecond laser is emitted in the second direction DR2, in order to determine the first isolation distance and the second isolation distance. For another example, while the femtosecond laser is fixed, the speeds at which the wafer WF is moved in the first and second directions DR1 and DR2 may be differently set to adjust the first and second isolation distances.

The first and second reflecting layers RFT1 and RFT2 may each include a DBR, and the DBR may be damaged by the laser beam LB. Therefore, the second reflecting layer RFT2 disposed on the other surface of the wafer WF, i.e. the surface onto which the laser beam LB is emitted, may be removed along the scribe line SL, and damage to the second reflecting layer RFT2 by the laser beam LB may be prevented while the laser beam LB is emitted.

In the case of the first reflecting layer RFT1, the process of removing the first reflecting layer RFT1 along the scribe line SL may be omitted when the emission depth of the laser beam LB accurately coincides with the thickness of the wafer WF. For another example, when the emission depth of the laser beam LB is larger than the thickness of the wafer WF, the process of removing the first reflecting layer RFT1 along the scribe line SL may be performed.

Referring to FIGS. 15A, 15B, 16A and 16B, an expansion tape EXT may be bonded to the other surface of the wafer WF on which the laser beam emission process has been performed. The expansion tape EXT may be temporarily bonded to the other surface of the wafer WF through an attachable/detachable adhesive.

After the expansion tape EXT is bonded, the protective film PRT may be removed to expose the light emitting structures on the one surface 102 of the wafer WF again.

The expansion tape EXT may be expanded toward an end so as to rupture the wafer WF, onto which the laser beam LB has been emitted, along the scribe line SL, in order to form a plurality of light emitting chips LEC. The plurality of light emitting chips LEC may be disposed so as to be isolated from each other in the first and second directions DR1 and DR2.

Each of the light emitting chips LEC include a substrate SUB and a light emitting structure disposed on one surface 102 of the substrate SUB. The substrate SUB may have the same size as the chip region CR, and include first side surfaces SD1 and second side surfaces SD2. The first side surfaces SD1 may be cut in the first direction DR1 so as to face each other, and the second side surfaces SD2 may be cut in the second direction DR2 so as to face each other. Referring to FIG. 16A, each of the first side surfaces SD1 may have an angle α of 88.5° to 91.5° with respect to the one surface 102 of the substrate SUB. Referring to FIG. 16B, each of the second side surfaces SD2 may have an angle β of 88.5° to 91.5° with respect to the one surface 102 of the substrate SUB. That is, the first side surfaces SD1 and the second side surfaces SD2 may be substantially perpendicular to the one surface 102 of the substrate SUB.

In accordance with an embodiment, referring to FIGS. 15B and 16A, the surfaces cut in the first direction DR1 may include an a-plane group. Each of the first side surfaces SD1 cut in the first direction DR1 include the first modified regions MDF1 and first ruptured regions CT1 disposed between the respective first modified regions MDF1. The first modified regions MDF1 are portions modified by the laser beam LB, and the first ruptured regions CT1 are portions physically cut by the expansion of the expansion tape EXT. As described above, the first modified regions MDF1 are continuously formed in the thickness direction of the wafer WF. Therefore, the first ruptured regions CT1 which are physically cut may also be continuously extended in the thickness direction of the wafer WF, i.e. the substrate SUB, thereby having a lined shape. The first modified regions MDF1 have a first width WT1, and the first ruptured regions CT1 have a second width WT2 larger than the first width WT1. As described above, the neighboring first modified regions MDF1 may be isolated by the first isolation distance from each other. Therefore, the second width WT2 may be equal to the first isolation distance.

For convenience of description, the plane at which an end of the first side surface SD1 and an end of the second side surface SD2 in the substrate SUB meet each other is referred to as a corner CN. Furthermore, the point at which the one surface 102, the first side surface SD1 and the second side surface SD2 of the substrate meet one another is referred to as a corner point.

In accordance with an embodiment, the first ruptured regions CT1 each include a first cut region ECT1 at the corner CN. More specifically, the first modified regions MDF1 include a first-first modified region MDF1-1 and a first-second modified region MDF1-2. The first-first modified region MDF1-1 is the closest to the corner CN, and the first-second modified region MDF1-2 is positioned next to the first-first modified region MDF1-1. The first cut region ECT1 corresponds to a section between the corner CN and the first-first modified region MDF1-1. The width between the corner CN and the first-first modified region MDF1-1 is smaller than the width between the first-first modified region MDF1-1 and the first-second modified region MDF1-2. Therefore, the first cut region ECT1 has a third width WT3 smaller than the second width WT2. The first cut region ECT1 may be a section formed by cutting the first ruptured region CT1 at a portion adjacent to the corner CN while the wafer WF is physically ruptured by emitting the laser beam LB in the first direction DR1.

Referring to FIGS. 15B and 16B, the surfaces cut in the second direction DR2 may include an m-plane group. The second side surfaces SD2 cut in the second direction DR2 may include the second modified regions MDF2 and second ruptured regions CT2 disposed between the respective second modified regions MDF2. The second modified regions MDF2 may be portions modified by the laser beam LB, and the second ruptured regions CT2 may be portions physically cut by the expansion of the expansion tape EXT. As described above, each of the second modified regions MDF2 may be continuously formed in the thickness direction of the wafer WF. Therefore, the second ruptured regions CT2 which are physically ruptured may also be continuously extended in the thickness direction of the wafer WF, i.e. the substrate SUB, thereby having a lined shape. The second modified region MDF2 may have the first width WT1, and the second ruptured region CT2 may have a fourth width WT4 larger than the first width WT1. As described above, the neighboring second modified regions MDF2 may be isolated by the second isolation distance from each other. Therefore, the fourth width WT4 may be equal to the second isolation distance.

In accordance with an embodiment, the second ruptured regions CT2 may each include a second cut region ECT2 at the corner CN. More specifically, the second modified regions MDF2 may include a second-first modified region MDF2-1 and a second-second modified region MDF2-2. The second-first modified region MDF2-1 may be the closest to the corner CN, and the second-second modified region MDF2-2 may be positioned next to the second-first modified region MDF2-1. The second cut region ECT2 may correspond to a section between the corner CN and the second-first modified region MDF2-1. The width between the corner CN and the second-first modified region MDF2-1 may be smaller than the width between the second-first modified region MDF2-1 and the second-second modified region MDF2-2. Therefore, the second cut region ECT2 may have a fifth width WT5 smaller than the fourth width WT4. The second cut region ECT1 may be a section formed by cutting the second ruptured region CT2 at a portion close to the corner CN while the wafer WF onto which the laser beam LB has been emitted is physically ruptured in the second direction DR2.

In accordance with the invention, the modified regions MDF have a lined shape to pass through the substrate SUB, and include the first modified regions MDF1 and the second modified regions MDF2. The first modified regions MDF1 may be isolated by the second width WT2 from each other in the first direction DR1, and the second modified regions MDF2 may be isolated by the fourth width WT4 from each other in the second direction DR2. In particular, as the second modified regions MDF2 are formed more densely than the first modified regions MDF1, the m-plane exposed in the second direction DR2 may be formed perpendicular to the one surface 102 of the substrate SUB.

In accordance with an embodiment, the light emitting chip LEC includes the substrate SUB, the light emitting structure formed on the one surface 102 of the substrate SUB, and the second reflecting layer RFT2 formed on the other surface of the substrate SUB. The light emitting structure may include the first conductive type semiconductor layer 110, the mesa structure MS, the first conductive pattern CP1, the second conductive pattern CP2, the first reflecting layer RFT1, the first pad PD1 and the second pad PD2. The first conductive type semiconductor layer 110 may be formed on the one surface 102 of the substrate SUB, and have a smaller width than the width of the substrate SUB, and the mesa structure MS may be formed on the first conductive type semiconductor layer 110, and have a smaller width than the width of the first conductive type semiconductor layer 110. The mesa structure MS may include the active layer 120, the second conductive type semiconductor layer 130 and the ohmic layer 140. In this case, the other surface of the substrate SUB in the light emitting chip LEC may serve as a light extraction surface. Most part of light emitted from the active layer 120 of the light emitting chip LEC may be reflected toward the substrate SUB by the first reflecting layer RFT1, and the other part of the light may be reflected toward the light emitting structure by the second reflecting layer RFT2. Therefore, 20 to 30% of the light generated by the active layer 120 in the light emitting chip LEC may be discharged through the light extraction surface. The rest of the light, i.e. 70 to 80% of the light, may be emitted through the first side surfaces SD1 and the second side surfaces SD2 of the substrate SUB.

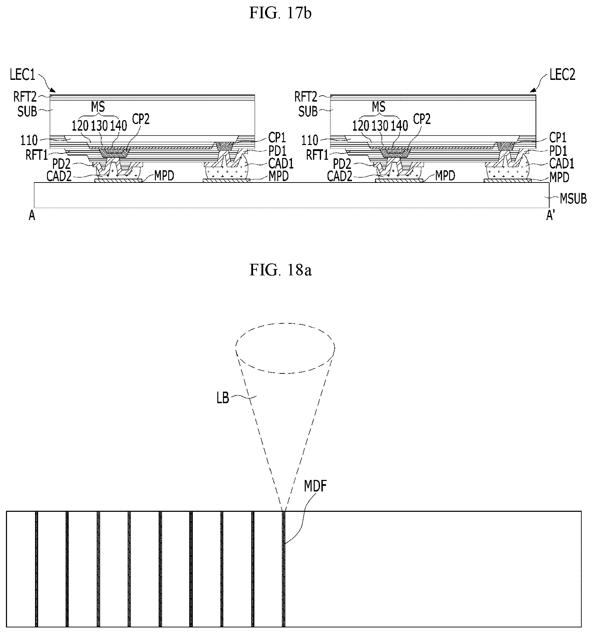

Referring to FIGS. 17A and 17B, the light emitting chips LEC are picked up and mounted on a mounting substrate MSUB, thereby forming a light emitting module according to the invention FIG. 17B is a cross-sectional view of the light emitting chips of FIG. 17A, taken along line A-A'.

Since the first side surfaces SD1 and the second side surfaces SD2 of the substrate SUB are substantially perpendicular to the one surface 102 of the substrate SUB, the light emitting chips LEC may be neither rotated while picked up and moved, nor fall down even after being mounted on the mounting substrate MSUB.

The first and second conductive adhesion parts CAD1 and CAD2 in each of the light emitting chips LED mounted on the mounting substrate MSUB are electrically bonded to mounting pads MPD of the mounting substrate MSUB, respectively. For example, as illustrated in FIGS. 10A and 10B, the first and second conductive adhesion parts CAD1 and CAD2 may be formed on the light emitting chip LEC. For another example, the first conductive adhesion part CAD1 and the second conductive adhesion part CAD2 may be formed on the respective mounting pads MPD of the mounting substrate MSUB. For another example, the first and second conductive adhesion parts CAD1 and CAD2 may be formed on the light emitting chip LEC, and third and fourth conductive adhesion parts are further formed on the respective mounting pads MPD, such that the first conductive adhesion part CAD1 is electrically contacted with the third conductive adhesion part, and the second conductive adhesion part CAD2 is electrically contacted with the fourth conductive adhesion part.

In accordance with an embodiment, when the thickness of each of the light emitting chips LEC is relatively large in comparison to the area thereof even though the first side surfaces SD1 and the second side surfaces SD2 of the substrate SUB in the light emitting chip LEC are substantially perpendicular to the one surface 102 of the substrate SUB, the light emitting chip LEC may fall down. Therefore, when the light emitting chip LEC has an area of 40,000um² or less, the thickness of the light emitting chip LEC needs to be smaller than 1/2 of one side thereof. For example, when the width and length of the light emitting chip LEC are each 200um, the light emitting chip LEC may have a thickness of 100um or less.

Furthermore, light generated from the active layer 120 may be scattered at the first modified regions MDF1 of the first side surfaces SD1 and the second modified regions MDF2 of the second side surfaces SD2 in the substrate SUB of each of the light emitting chips LEC, which makes it possible to improve the light extraction efficiency of the light emitting chips LEC.

**In** the present embodiment, the light emitting chips LEC include a first light emitting chip LEC1, a second light emitting chip LEC2, a third light emitting chip LEC3 and a fourth light emitting chip LEC4. The first to fourth light emitting chips LEC1 to LEC4 have the same structure.

As described above, the light emitting chips LEC are not rotated when picked up and moved. Therefore, side surfaces facing each other in the light emitting chips LEC disposed on the mounting substrate MSUB have the same structure. According to the invention, one of the first side surfaces SD1 of the substrate SUB of the first light emitting chip LEC1 faces one of the first side surfaces SD1 of the substrate SUB of the second light emitting chip LEC2, and one of the second side surfaces SD2 of the substrate SUB of the first light emitting chip LEC1 may face one of the second side surfaces SD2 of the substrate SUB of the third light emitting chip LEC3.

Furthermore, the respective corners of the first to fourth light emitting chips LEC1 to LEC4 face each other. As described above, the first and second cut regions ECT1 and ECT2 are formed at each of the corners. The first cut region ECT1 has a smaller width than the first ruptured regions CT1, and the second cut region ECT2 has a smaller width than the second ruptured regions CT2, which indicates that the modified regions MDF are disposed close to the corner. Therefore, the modified regions MDF at the respective corners facing each other may prevent total reflection of light, thereby improving the light extraction efficiency.

In general, the light generated from the active layer 120 of the light emitting chip is absorbed, reflected and dissipated while passing through the light emitting structure and the substrate SUB without the second reflecting layer RFT2, and then emitted through the other surface of the substrate SUB. Suppose that the total amount of light during this cycle is set to 100%. In this case, the amount of light emitted through the other surface of the substrate SUB by the first and second reflecting layers RFT1 and RFT2 in the light emitting chip in accordance with the embodiments of the present disclosure may correspond to 20 to 30% of the total amount of light. The rest of the light, i.e. 70 to 80% of the total amount of light, may be emitted through the first side surfaces SD1 and the second side surfaces SD2 of the substrate SUB.

Therefore, since the amount of light emitted in the horizontal direction is larger than the amount of light emitted in the vertical direction, the light emitting chips LEC in accordance with the embodiments have uniform luminance. The light emitting chips LEC may be used in a BLU (Back Light Unit) which requires uniform luminance.

Hereafter, a wafer cut by the process in accordance with the embodiments of the present disclosure will be described.

FIG. 18A is a schematic diagram for describing a method using laser to cut a wafer in accordance with an embodiment of the present disclosure.

First, a wafer is prepared, which has a m-axis direction set to a first direction parallel to the extension direction of a flat zone, and an a-axis direction set to a second direction perpendicular to the first direction. A desired substrate formed by cutting the wafer has a size of 200um x 200um x 85um.

Referring to FIG. 18A, line-shaped modified regions MDF are formed by successively emitting laser beams LB in the thickness direction of the wafer. The laser beams LB form the modified regions MDF which are isolated by a first isolation distance from each other in the first direction, and the modified regions MDF which are isolated by a second isolation distance from each other in the second direction, the second isolation distance being smaller than the first isolation distance. When the wafer having the line-shaped modified regions formed therein is ruptured, ruptured regions which are continuously extended in the thickness direction are formed between the respective modified regions, and cut into a plurality of substrates.

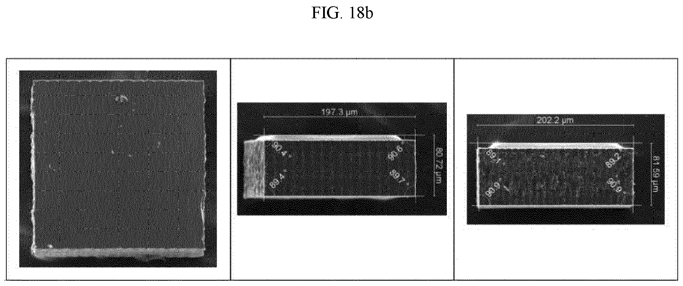

FIG. 18B shows photographs of a substrate formed through the method described with reference to FIG. 18A. In FIG. 18B, the left photograph is a photograph of the top surface of the substrate, the middle photograph is a photograph acquired by tilting a first side surface of the wafer cut in the first direction, and the right photograph is a photograph of a second side surface of the wafer cut in the second direction. A left portion of the middle photograph shows a part of the second side surface.

FIG. 18B shows that the cut substrate is substantially perpendicular. The angles between the top surface of the substrate and the first and second side surfaces may be substantially perpendicular in a range of 88.9° to 90.6°. Furthermore, the modified regions and the ruptured regions are parallel to the thickness direction of the substrate.

While various embodiments have been described above, it will be understood to those skilled in the art that the embodiments described are by way of example only. Accordingly, the disclosure described herein should not be limited based on the described embodiments.

## Claims

1. A light emitting module comprising:
a mounting substrate (MSUB); a plurality of light emitting chips (LEC, LEC1, LEC2) mounted on the mounting substrate; and
a plurality of pads (MPD) disposed between the light emitting chips and the mounting substrate,
wherein the plurality of light emitting chips comprises:
a first substrate (SUB) of a first light emitting chip (LEC1);
a first light emitting unit of the first light emitting chip (LEC1) disposed on one surface of the first substrate;
a second substrate(SUB) of a second light emitting chip (LEC2) isolated from the first substrate; and
a second light emitting unit of the second light emitting chip (LEC2) disposed on one surface of the second substrate,
wherein one side surface (SD1) of the first substrate comprises a first modified surface, and one side surface (SD1) of the second substrate, facing the one side surface of the first substrate, comprises a second modified surface,
the first modified surface comprises modified regions (MDF1) extended in the thickness direction of the first substrate and ruptured regions (CT1) disposed between the respective modified regions,
the second modified surface comprises modified regions (MDF1) extended in the thickness direction of the second substrate and ruptured regions (CT1) disposed between the respective modified regions, and
wherein the ruptured regions of the first modified surface have a first width (WT2), and
the first modified surface further comprises a cut region (ECT1) having a second width (WT3) smaller than the first width, and formed between the corner (CN) at which the one side surface and the other side surface adjacent to the one side surface meet each other and the modified region (MDF1-1) which is the closest to the corner, and
wherein the ruptured regions of the first modified surface have the same width as those of the second modified surface,
**characterized in that** each of the modified regions have a line shape to pass through the corresponding substrate.

2. The light emitting module of claim 1, wherein each of the modified regions is modified by laser irradiation thereto.

3. The light emitting module of claim 1, wherein the width of each of the ruptured regions is larger than that of each of the modified regions.

4. The light emitting module of claim 1, wherein the other side surface of the first substrate, adjacent to the one side surface thereof, comprises a third modified surface, and
the third modified surface comprises modified regions extended in the thickness direction of the first substrate and ruptured regions disposed between the respective modified regions.

5. The light emitting module of claim 4, wherein the width of each of the ruptured regions of the first modified surface is smaller than that of each of the ruptured regions of the third modified surface.

6. The light emitting module of claim 5, wherein when the first substrate includes sapphire,
the one side surface of the first substrate comprises an m-plane and a plane tilted with respect to the m-plane, and
the other side surface of the first substrate comprises an a-plane and a plane tilted with respect to the a-plane.

7. The light emitting module of claim 4, wherein the ruptured regions of the third modified surface have a first width, and
the third modified surface further comprises a cut region having a second width smaller than the first width, and formed between the corner at which the one side surface and the other side surface meet each other and the modified region which is the closest to the corner.

8. The light emitting module of claim 1, wherein the one side surface of the first substrate has a slope of 88.5° to 91.5° with respect to the interface between the first substrate and the first light emitting unit.

9. The light emitting module of claim 1, wherein the one side surface of the second substrate has a slope of 88.5° to 91.5° with respect to the interface between the second substrate and the second light emitting unit.

10. The light emitting module of claim 1, wherein the first emitting unit comprises:
a first conductive type semiconductor layer disposed on one surface of the first substrate;
an active layer disposed on the first conductive type semiconductor layer so as to expose a part of the first conductive type semiconductor layer;
a second conductive type semiconductor layer disposed on the active layer so as to expose a part of the first conductive type semiconductor layer;
a first reflecting layer configured to cover the first substrate, the first conductive type semiconductor layer, the active layer and the second conductive type semiconductor layer, and having a first hole and a second hole which expose the first and second conductive type semiconductor layers, respectively;
a first pad disposed on the first reflecting layer, and electrically connected to the first conductive type semiconductor layer through the first hole; and
a second pad disposed on the first reflecting layer, and electrically connected to the second conductive type semiconductor layer through the second hole.

11. The light emitting module of claim 10, wherein the first reflecting layer exposes the edge of the one surface of the first substrate.

12. The light emitting module of claim 10, further comprising a second reflecting layer disposed on the other surface of the first substrate, facing the one surface thereof on which the first light emitting unit is disposed.

13. The light emitting module of claim 12, wherein the first reflecting layer reflects two different wavelengths of lights, and
the second reflecting layer reflects one wavelength of light.

14. The light emitting module of claim 12, wherein the first reflecting layer has a larger thickness than the second reflecting layer.

15. The light emitting module of claim 12, wherein the second reflecting layer exposes the edge of the other surface of the first substrate.

## Patentansprüche

1. Lichtemittierendes Modul, umfassend:
ein Befestigungssubstrat (MSUB);
eine Vielzahl von lichtemittierenden Chips (LEC, LEC1, LEC2), die auf dem Befestigungssubstrat angebracht sind; und
eine Vielzahl von Pads (MPD), die zwischen den lichtemittierenden Chips und dem Befestigungssubstrat angeordnet sind,
wobei die mehreren lichtemittierenden Chips umfassen:
ein erstes Substrat (SUB) eines ersten lichtemittierenden Chips (LEC1);
eine erste lichtemittierende Einheit des ersten lichtemittierenden Chips (LEC1), die auf einer Oberfläche des ersten Substrats angeordnet ist;
ein zweites Substrat (SUB) eines zweiten lichtemittierenden Chips (LEC2), das vom ersten Substrat isoliert ist; und
eine zweite lichtemittierende Einheit des zweiten lichtemittierenden Chips (LEC2), die auf einer Oberfläche des zweiten Substrats angeordnet ist,
wobei eine Seitenfläche (SD1) des ersten Substrats eine erste modifizierte Oberfläche umfasst und eine Seitenfläche (SD1) des zweiten Substrats, die der einen Seitenfläche des ersten Substrats zugewandt ist, eine zweite modifizierte Oberfläche umfasst,
die erste modifizierte Oberfläche modifizierte Bereiche (MDF1) umfasst, die sich in Dickenrichtung des ersten Substrats erstrecken, sowie gebrochene Bereiche (CT1), die zwischen den jeweiligen modifizierten Bereichen angeordnet sind,
die zweite modifizierte Oberfläche umfasst modifizierte Bereiche (MDF1), die sich in Dickenrichtung des zweiten Substrats erstrecken, und zwischen den jeweiligen modifizierten Bereichen angeordnete Bruchbereiche (CT1)
wobei die gebrochenen Bereiche der ersten modifizierten Oberfläche eine erste Breite (WT2) aufweisen, und
die erste modifizierte Oberfläche ferner einen Schnittbereich (ECT1) umfasst, der eine zweite Breite (WT3) aufweist, die kleiner ist als die erste Breite, und der zwischen der Ecke (CN), an der die eine Seitenfläche und die an die eine Seitenfläche angrenzende andere Seitenfläche aufeinandertreffen, und dem modifizierten Bereich (MDF1-1), der der Ecke am nächsten liegt, konfiguriert ist, und
wobei die gebrochenen Bereiche der ersten modifizierten Oberfläche dieselbe Breite wie die der zweiten modifizierten Oberfläche aufweisen,
**dadurch gekennzeichnet, dass** jede der modifizierten Regionen eine Linienform aufweist, um durch das entsprechende Substrat zu verlaufen.

2. Lichtemittierendes Modul nach Anspruch 1, wobei jeder der modifizierten Bereiche durch Laserbestrahlung modifiziert ist.

3. Lichtemittierendes Modul nach Anspruch 1, wobei die Breite jedes der gebrochenen Bereiche größer ist als die jedes der modifizierten Bereiche.

4. Lichtemittierendes Modul nach Anspruch 1, wobei die andere Seitenfläche des ersten Substrats, die an dessen eine Seitenfläche angrenzt, eine dritte modifizierte Oberfläche umfasst, und
die dritte modifizierte Oberfläche modifizierte Bereiche, die sich in Dickenrichtung des ersten Substrats erstrecken, und zwischen den jeweiligen modifizierten Bereichen angeordnete aufgebrochene Bereiche umfasst.

5. Lichtemittierendes Modul nach Anspruch 4, wobei die Breite jedes der gebrochenen Bereiche der ersten modifizierten Oberfläche kleiner ist als die Breite jedes der gebrochenen Bereiche der dritten modifizierten Oberfläche.

6. Lichtemittierendes Modul nach Anspruch 5, wobei, wenn das erste Substrat Saphir enthält,
die eine Seitenfläche des ersten Substrats eine m-Ebene und eine gegenüber der m-Ebene geneigte Ebene umfasst, und
die andere Seitenfläche des ersten Substrats umfasst eine a-Ebene und eine gegenüber der a-Ebene geneigte Ebene.

7. Lichtemittierendes Modul nach Anspruch 4, wobei die gebrochenen Bereiche der dritten modifizierten Oberfläche eine erste Breite aufweisen und
die dritte modifizierte Oberfläche ferner einen Schnittbereich umfasst, der eine zweite Breite besitzt, die kleiner ist als die erste Breite, und der zwischen der Ecke, an der die eine Seitenfläche und die andere Seitenfläche aufeinandertreffen, und dem modifizierten Bereich, der der Ecke am nächsten liegt, konfiguriert ist.

8. Lichtemittierendes Modul nach Anspruch 1, wobei die eine Seitenfläche des ersten Substrats eine Neigung von 88,5° bis 91,5° in Bezug auf die Grenzfläche zwischen dem ersten Substrat und der ersten lichtemittierenden Einheit aufweist.

9. Lichtemittierendes Modul nach Anspruch 1, wobei die eine Seitenfläche des zweiten Substrats eine Neigung von 88,5° bis 91,5° in Bezug auf die Grenzfläche zwischen dem zweiten Substrat und der zweiten lichtemittierenden Einheit aufweist.

10. Lichtemittierendes Modul nach Anspruch 1, wobei die erste lichtemittierende Einheit umfasst:
eine Halbleiterschicht vom ersten Leitfähigkeitstyp, die auf einer Oberfläche des ersten Substrats angeordnet ist;
eine aktive Schicht, die auf der Halbleiterschicht des ersten Leitfähigkeitstyps so angeordnet ist, dass ein Teil der Halbleiterschicht des ersten Leitfähigkeitstyps freiliegt;
eine Halbleiterschicht eines zweiten Leitfähigkeitstyps, die auf der aktiven Schicht angeordnet ist, sodass ein Teil der Halbleiterschicht des ersten Leitfähigkeitstyps freiliegt;
eine erste reflektierende Schicht, die so konfiguriert ist, dass sie das erste Substrat, die Halbleiterschicht des ersten Leitfähigkeitstyps, die aktive Schicht und die Halbleiterschicht des zweiten Leitfähigkeitstyps bedeckt, und die ein erstes Loch und ein zweites Loch aufweist, die die Halbleiterschicht des ersten bzw. des zweiten Leitfähigkeitstyps freilegen;
ein erstes Pad, das auf der ersten reflektierenden Schicht angeordnet und über das erste Loch elektrisch mit der Halbleiterschicht des ersten Leitfähigkeitstyps verbunden ist; und
ein zweites Pad, das auf der ersten reflektierenden Schicht angeordnet ist und über das zweite Loch elektrisch mit der Halbleiterschicht des zweiten Leitfähigkeitstyps verbunden ist.

11. Lichtemittierendes Modul nach Anspruch 10, wobei die erste reflektierende Schicht den Rand der einen Oberfläche des ersten Substrats freilegt.

12. Lichtemittierendes Modul nach Anspruch 10, das ferner eine zweite reflektierende Schicht umfasst, die auf der anderen Oberfläche des ersten Substrats angeordnet ist und der einen Oberfläche desselben zugewandt ist, auf der die erste lichtemittierende Einheit angeordnet ist.

13. Lichtemittierendes Modul nach Anspruch 12, wobei die erste reflektierende Schicht zwei verschiedene Wellenlängen von Licht reflektiert und
die zweite reflektierende Schicht eine Wellenlänge des Lichts reflektiert.

14. Lichtemittierendes Modul nach Anspruch 12, wobei die erste reflektierende Schicht eine größere Dicke aufweist als die zweite reflektierende Schicht.

15. Lichtemittierendes Modul nach Anspruch 12, wobei die zweite reflektierende Schicht den Rand der anderen Oberfläche des ersten Substrats freilegt.

## Revendications

1. Module d'émission de lumière comprenant :
un substrat de montage (MSUB) ;
une pluralité de puces électroluminescentes (LEC, LEC1, LEC2) montées sur le substrat de montage ; et
une pluralité de plots (MPD) disposés entre les puces électroluminescentes et le substrat de montage,
dans lequel la pluralité de puces électroluminescentes comprend :
un premier substrat (SUB) d'une première puce émettrice de lumière (LEC1) ;
une première unité d'émission de lumière de la première puce d'émission de lumière (LEC1) disposée sur une surface du premier substrat ;
un deuxième substrat (SUB) d'une deuxième puce émettrice de lumière (LEC2) isolé du premier substrat ; et
une deuxième unité d'émission de lumière de la deuxième puce d'émission de lumière (LEC2) disposée sur une surface du deuxième substrat,
dans lequel une surface latérale (SD1) du premier substrat comprend une première surface modifiée, et une surface latérale (SD1) du deuxième substrat, faisant face à ladite surface latérale du premier substrat, comprend une deuxième surface modifiée,
la première surface modifiée comprend des régions modifiées (MDF1) s'étendant dans le sens de l'épaisseur du premier substrat et des régions rompues (CT1) disposées entre les régions modifiées respectives,
la deuxième surface modifiée comprend des régions modifiées (MDF1) s'étendant dans le sens de l'épaisseur du deuxième substrat et des régions rompues (CT1) disposées entre les régions modifiées respectives, et
dans lequel les zones rompues de la première surface modifiée présentent une première largeur (WT2), et
la première surface modifiée comprend en outre une zone découpée (ECT1) présentant une deuxième largeur (WT3) inférieure à la première largeur, et formée entre le coin (CN) où la première surface latérale et l'autre surface latérale adjacente à celle-ci se rejoignent, et la zone modifiée (MDF1-1) la plus proche du coin, et
dans lequel les zones rompues de la première surface modifiée ont la même largeur que celles de la deuxième surface modifiée,
**caractérisé en ce que** chacune des zones modifiées présente une forme linéaire permettant de traverser le substrat correspondant.

2. Module d'émission de lumière selon la revendication 1, dans lequel chacune des zones modifiées est modifiée par irradiation laser.

3. Module d'émission de lumière selon la revendication 1, dans lequel la largeur de chacune des zones rompues est supérieure à celle de chacune des zones modifiées.

4. Module d'émission de lumière selon la revendication 1, dans lequel l'autre surface latérale du premier substrat, adjacente à ladite une surface latérale de celui-ci, comprend une troisième surface modifiée, et
la troisième surface modifiée comprend des zones modifiées s'étendant dans le sens de l'épaisseur du premier substrat et des zones rompues disposées entre les zones modifiées respectives.

5. Module d'émission de lumière selon la revendication 4, dans lequel la largeur de chacune des zones rompues de la première surface modifiée est inférieure à celle de chacune des zones rompues de la troisième surface modifiée.

6. Module d'émission de lumière selon la revendication 5, dans lequel, lorsque le premier substrat comprend du saphir,
une face latérale du premier substrat comprend un plan m et un plan incliné par rapport au plan m, et
l'autre surface latérale du premier substrat comprend un plan a et un plan incliné par rapport au plan a.

7. Module d'émission de lumière selon la revendication 4, dans lequel les zones rompues de la troisième surface modifiée ont une première largeur, et
la troisième surface modifiée comprend en outre une zone découpée ayant une deuxième largeur inférieure à la première largeur, et formée entre le coin où la première surface latérale et la deuxième surface latérale se rejoignent et la zone modifiée la plus proche de ce coin.

8. Module d'émission de lumière selon la revendication 1, dans lequel la surface latérale du premier substrat présente une pente comprise entre 88,5° et 91,5° par rapport à l'interface entre le premier substrat et la première unité d'émission de lumière.

9. Module d'émission de lumière selon la revendication 1, dans lequel ladite surface latérale du deuxième substrat présente une pente comprise entre 88,5° et 91,5° par rapport à l'interface entre le deuxième substrat et la deuxième unité d'émission de lumière.

10. Module d'émission de lumière selon la revendication 1, dans lequel la première unité d'émission comprend :
une première couche semi-conductrice de type conducteur disposée sur une surface du premier substrat ;
une couche active disposée sur la couche semi-conductrice de premier type conducteur de manière à exposer une partie de la couche semi-conductrice de premier type conducteur ;
une deuxième couche semi-conductrice de type conducteur disposée sur la couche active de manière à exposer une partie de la première couche semi-conductrice de type conducteur ;
une première couche réfléchissante configurée pour recouvrir le premier substrat, la première couche semi-conductrice de type conducteur, la couche active et la deuxième couche semi-conductrice de type conducteur, et comportant un premier trou et un deuxième trou qui exposent respectivement les première et deuxième couches semiconductrices de type conducteur ;
un premier plot disposé sur la première couche réfléchissante, et connecté électriquement à la première couche semi-conductrice de type conducteur par l'intermédiaire du premier trou ; et
un deuxième plot disposé sur la première couche réfléchissante, et connecté électriquement à la couche semi-conductrice de deuxième type conducteur par l'intermédiaire du deuxième trou.

11. Module d'émission de lumière selon la revendication 10, dans lequel la première couche réfléchissante expose le bord de l'une des faces du premier substrat.

12. Module d'émission de lumière selon la revendication 10, comprenant en outre une deuxième couche réfléchissante disposée sur l'autre surface du premier substrat, en regard de ladite une surface de celui-ci sur laquelle est disposée la première unité d'émission de lumière.

13. Module d'émission de lumière selon la revendication 12, dans lequel la première couche réfléchissante réfléchit deux longueurs d'onde de lumière différentes, et
la deuxième couche réfléchissante réfléchit une longueur d'onde de lumière.

14. Module d'émission de lumière selon la revendication 12, dans lequel la première couche réfléchissante présente une épaisseur supérieure à celle de la deuxième couche réfléchissante.

15. Module d'émission de lumière selon la revendication 12, dans lequel la deuxième couche réfléchissante laisse apparaître le bord de l'autre surface du premier substrat.
